# EUROPEAN PATENT APPLICATION

(11) **EP 4 832 731 A2**
(43) Date of publication of application: **28.10.2026**
(21) Application number: 26171398.6
(22) Date of filing: 09.04.2026
(51) Int. Cl.: H10P 72/00, H10P 72/30

(54) **SUBSTRATE TYPE IDENTIFICATION APPARATUS, SUBSTRATE PROCESSING APPARATUS, METHOD OF PROCESSING SUBSTRATE, METHOD OF MANUFACTURING SEMICONDUCTOR DEVICE, AND PROGRAM**

(30) Priority: 25.04.2025 JP 2025073771
(71) Applicant: Kokusai Electric Corporation, Tokyo 100-0004 (JP)
(72) Inventor: OTA, Takayuki, Toyama-shi, Toyama 939-2393 (JP); TSUCHIYA, Tomoki, Toyama-shi, Toyama 939-2393 (JP)
(74) Representative: Bardehle Pagenberg Partnerschaft mbB Patentanwälte Rechtsanwälte

(57) **Abstract**

A technique includes: an imager configured to acquire a two-dimensional image by collectively capturing a plurality of substrates, which are arranged and accommodated in a substrate container, from a direction inclined relative to main surfaces of at least one of the plurality of substrates; and an identifier configured to be capable of individually identifying materials of the plurality of substrates based on a plurality of pixel values in the acquired two-dimensional image corresponding to the plurality of substrates.

## Description

### CROSS-REFERENCE TO RELATED APPLICATION

This application is based upon and claims the benefit of priority from Japanese Patent Application No. 2025-073771, filed on April 25, 2025, the entire content of which is incorporated herein by reference.

### TECHNICAL FIELD

The present disclosure relates to a substrate type identification apparatus, a substrate processing apparatus, a method of processing a substrate, a method of manufacturing a semiconductor device, and a program.

### BACKGROUND

**In** the related art, wafers (substrates) made of different materials such as silicon (Si) and silicon carbide (SiC) may be loaded into a substrate processing apparatus separately or in a mixture of both.

### SUMMARY

Some embodiments of the present disclosure provide a technique capable of identifying the material of a substrate.

According to an embodiment of the present disclosure, there is provided a technique that includes: an imager configured to acquire a two-dimensional image by collectively capturing a plurality of substrates, which are arranged and accommodated in a substrate container, from a direction inclined relative to main surfaces of at least one of the plurality of substrates; and an identifier configured to be capable of individually identifying materials of the plurality of substrates based on a plurality of pixel values in the acquired two-dimensional image corresponding to the plurality of substrates.

### BRIEF DESCRIPTION OF DRAWINGS

The accompanying drawings, which are incorporated in and constitute a part of the specification, illustrate embodiments of the present disclosure.
FIG. 1 is a schematic perspective view illustrating a configuration of a substrate processing apparatus.
FIG. 2 is a side cross-sectional view illustrating a vicinity of a front surface (a cassette shelf) of the substrate processing apparatus.
FIG. 3 is a diagram illustrating a schematic configuration of a controller of the substrate processing apparatus.
FIG. 4 is a diagram illustrating a processing flow of a substrate processing method.
FIG. 5 is a diagram illustrating a flow of secondary wafer mapping.
FIG. 6 is a diagram for explaining a setting of a region of interest (RoI).
FIG. 7 is a diagram for explaining a range of imaging angles of a camera.
FIG. 8 is a diagram illustrating a learning flow of a model.
FIG. 9 is a diagram illustrating a flow of secondary wafer mapping according to a modification.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

Hereinafter, one embodiment of the present disclosure will be described with reference to the drawings. The drawings used in the following description are schematic. A relationship between the dimensions of respective elements, the ratios of respective elements, and the like shown in the drawing do not always match the actual ones. Further, even among the drawings, the relationship between the dimensions of respective elements, the ratios of respective elements, and the like do not always match. In addition, throughout the drawings, substantially the same elements are designated by the same reference numerals. Each element will be described in the drawing in which the element appears first, and the description thereof will be omitted in subsequent drawings unless specially required. Unless otherwise stated in the specification, each element is not limited to one and may exist in plurality.

### (1) Substrate Processing Apparatus

In the embodiment, a substrate processing apparatus (hereinafter also referred to simply as a processing apparatus) is configured, for example, as a semiconductor manufacturing apparatus that performs a processing process in a method of manufacturing a semiconductor device.

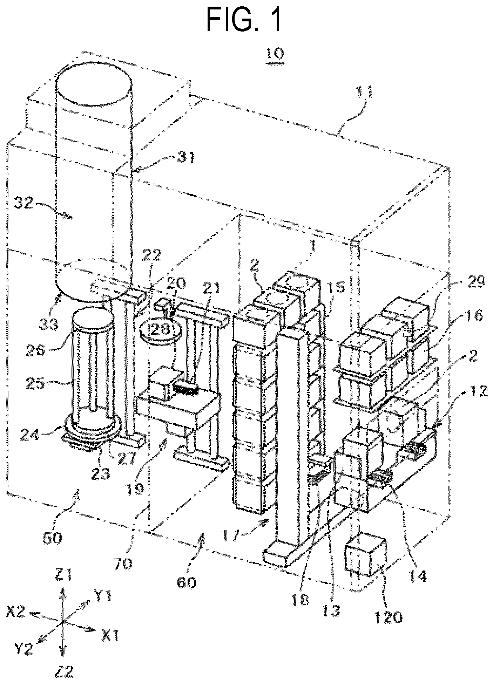

As illustrated in FIG. 1, a processing apparatus 10 according to the embodiment includes a housing 11. An interior of the housing 11 is divided into a transfer chamber 50 and a cassette holding chamber 60 by a wall portion 70. A cassette deliverer 12 is installed on a front surface of the housing 11, that is, a front surface (X1 side) of the cassette holding chamber 60. The X1-X2 direction corresponds to a front-rear direction of the processing apparatus 10, the Y2-Y1 direction corresponds to a left-right direction, and the Z1-Z2 direction corresponds to an up-down direction. The cassette deliverer 12 includes a cassette stage 13 capable of loading one or two cassettes 2 serving as substrate containers, which are carriers of wafers 1 serving as substrates. Two sets of wafer posture aligners 14 are installed below the cassette stage 13. The cassette 2 is also referred to as an open cassette. The cassette deliverer 12 is also referred to as a cassette loader, a load port, or an input/output (I/O) port. The cassette stage 13 receives the cassette 2, which is transferred by an external transferrer (not shown), in a vertical posture. Here, the vertical posture refers to a state in which the wafers 1 accommodated in the cassette 2 are positioned vertically.

The wafer posture aligners 14 align the posture of the wafers 1 such that notches of the wafers 1 accommodated in the vertically positioned cassette 2 are aligned with one another. The cassette stage 13 is configured to be capable of rotating the cassette 2 by 90 degrees between a vertical posture and a horizontal posture. Here, the horizontal posture refers to a state in which the wafers 1 accommodated in the cassette 2 are horizontal and in which an access opening of the cassette 2 faces the X2 direction. A cassette shelf 15 is installed in the cassette holding chamber 60 so as to face the cassette deliverer 12, and an auxiliary cassette shelf 16 is installed above the cassette deliverer 12. The cassette holding chamber 60 is installed with a camera 29 as an imager.

A cassette transporter 17 is installed between the cassette deliverer 12 and the cassette shelf 15. The cassette transporter 17 includes a robot arm 18 configured to be capable of advancing and retracting the cassette in a horizontal posture in a front-rear direction (X1-X2 direction), and the robot arm 18 is configured to be movable in the left-right direction and in the up-down direction. Through advancing and retracting (forward and rearward), moving left to right, and moving up and down, the robot arm 18 transports the cassette 2 in the horizontal posture on the cassette stage 13 to the cassette shelf 15 or the auxiliary cassette shelf 16. The cassette shelf 15 and the auxiliary cassette shelf 16 function as buffers that store the loaded wafers 1, in a state of being accommodated in the cassette 2 used when being loaded into the processing apparatus 10, until required.

A wafer transferrer 19 and a boat elevator 22 are installed in the transfer chamber 50. The wafer transferrer (transfer device) 19 is installed on a rear side (X2 side) of the cassette shelf 15 so as to be rotatable and vertically movable and transfers the wafers 1 in the cassette 2 onto a boat 25 serving as a substrate holder, either in batches or one by one. The wafer transferrer 19 includes an advancing and retracting actuator 20 for advancing and retracting a plurality of wafer holding plates 21 and is capable of accessing the facing cassette 2 in the cassette shelf 15 through an opening in the wall portion 70. The wafer holding plates 21 are also referred to as end effectors, tweezers, or forks.

The boat elevator 22 is installed on a rear side (X2 side) of the wafer transferrer 19 and holds a seal cap 24 such that the seal cap 24 is movable up and down via an arm 23.

The processing apparatus 10 includes a reaction tube (a processing tube or a process container) 31 made of a material with high heat resistance such as quartz or SiC, and the reaction tube 31 is vertically disposed such that a tube axis of the reaction tube 31 is oriented vertically. A cylindrical hollow portion of the reaction tube 31 forms a process chamber 32 in which the plurality of wafers 1 is accommodated, and a lower end of the reaction tube 31 is open toward the transfer chamber 50 to form a furnace port 33 for loading and unloading the wafers 1. The furnace port 33 is closed by the seal cap 24.

The seal cap 24, which closes the furnace port 33, is configured to come into contact with a lower end surface of the reaction tube 31 from below in the vertical direction. The seal cap 24 is formed in a disc shape and is configured to be raised or lowered vertically by the boat elevator 22 installed outside the reaction tube 31. When the seal cap 24 is moved to a lower end position thereof, a furnace opening shutter 28 can be installed to seal the furnace port 33.

The boat 25 for holding the wafers 1 is vertically erected and supported on the seal cap 24. The boat 25 includes a pair of upper and lower end plates 26 and 27, and a plurality of (three in the embodiment) holders (columns) disposed vertically and bridged between the end plates 26 and 27. Each holder is installed with multiple sets of holding grooves that are disposed at equal intervals in a longitudinal direction and are recessed such that openings thereof face one another. Outer peripheral edges of the wafers 1 are respectively inserted to each of the multiple sets of holding grooves of the holders so that the wafers 1 are horizontally held in the boat 25 with centers of the wafers 1 aligned with one another.

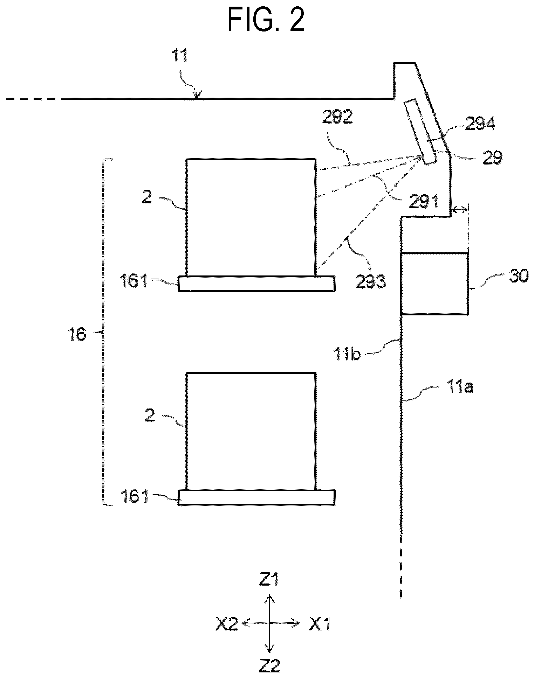

Installation of the camera 29 will be described with reference to FIGS. 1 and 2.

The camera 29 is disposed at an upper portion on a rear wall 11b side facing a front wall 11a of the housing 11 and is installed so as to face the cassette 2 which is in a horizontal posture and is placed at a center of an upper mounting stand 161 of the auxiliary cassette shelf 16. A signal lamp 30 for notifying an operator of a status of the apparatus is installed at the front wall 11a. The front wall 11a in a vicinity of the camera 29 is configured to protrude farther forward than the front wall 11a below the camera 29 but not beyond the signal lamp 30.

In FIG. 2, an optical axis 291 and viewing angles 292 and 293 of the camera 29 are illustrated. In this example, the optical axis 291 of the camera 29 is directed toward the wafers 1, which are exposed through a bottom opening (X1 side) of the cassette 2 and is configured such that the entirety of the wafers 1 arranged horizontally can be accommodated within a range of the viewing angles 292 and 293. Accordingly, the camera 29 is capable of collectively capturing an image of main surfaces of at least one of the wafers 1 in the cassette 2 from an inclined direction.

The camera 29 may be directed toward the horizontally positioned cassette 2 with the cassette 2 placed on a left side or a right side of the upper mounting stand 161 of the auxiliary cassette shelf 16 or may be directed toward the horizontally positioned cassette 2 with the cassette 2 placed at any of a left, center, or right side of a lower mounting stand 161 of the auxiliary cassette shelf 16. Alternatively, the camera 29 may be directed diagonally upward from below the cassette 2.

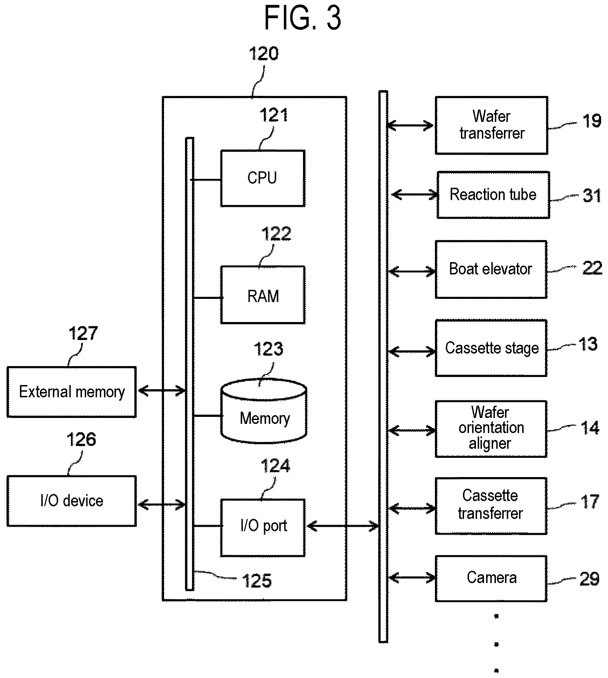

A controller 120, which serves as a control part (a control means or unit), will be described with reference to FIG. 3.

The controller 120 is constituted as a computer including a central processing unit (CPU) 121, a random access memory (RAM) 122, a memory 123, and an I/O port 124. The RAM 122, the memory 123, and the I/O port 124 are configured to exchange data with the CPU 121 via an internal bus 125. An I/O device 126 constituted as, for example, a touch panel or the like is connected to the controller 120. Additionally, an external memory 127 can be connected to the controller 120. The controller 120 is also configured to be capable of executing an artificial intelligence (AI) program.

The controller 120 serving as an identifier is configured to cause the camera 29 to capture an image of the cassette 2 while the cassette 2 transported by the cassette transporter 17 is placed on the auxiliary cassette shelf 16 and to determine materials of the wafers 1 in the cassette 2 from the captured two-dimensional image. The controller 120 and the camera 29 constitute a substrate type identification apparatus.

The memory 123 is constituted by, for example, a flash memory, a hard disk drive (HDD), and a solid state drive (SSD), or the like. A control program for controlling operations of the substrate processing apparatus, a process recipe in which procedures or conditions of substrate processing process to be described later are written, or the like is readably stored in the memory 123. The process recipe is a combination that causes, by the controller 120, the substrate processing apparatus to execute procedures in the substrate processing process to be described later, so as to obtain a predetermined result, and functions as a program. Hereinafter, the process recipe and the control program may be generally and simply referred to as a "program," and the process recipe may be referred to simply as a "recipe." When the term "program" is used in this specification, it may indicate a case of including the recipe, a case of including the control program, or a case of including both the recipe and the control program. The RAM 122 is constituted as a memory area (work area) in which a program, data, or the like read by the CPU 121 is temporarily stored.

The I/O port 124 is connected to the wafer transferrer 19, the reaction tube 31, the boat elevator 22, the cassette stage 13, the wafer posture aligners 14, the cassette transporter 17, the camera 29, and the like.

The CPU 121 is configured to be capable of reading and executing the control program from the memory 123. The CPU 121 is also configured to be capable of reading the recipe from the memory 123 in response to input of an operation command from the I/O device 126. According to contents of the read recipe, the CPU 121 is configured to be capable of controlling transfer operation of the wafers 1 by the wafer transferrer 19, supply and exhaust operations of a process gas to and from the reaction tube 31, flow rate regulation operation of the process gas, pressure control and temperature regulation operations of the process chamber 32, and raising and lowering operations of the boat 25 by the boat elevator 22. Additionally, the CPU 121 is configured to be capable of controlling raising, lowering, and rotating operations of the cassette 2 by the cassette stage 13, posture alignment operation of the wafers 1 by the wafer posture aligners 14, transport operation of the cassette 2 by the cassette transporter 17, and imaging operation of the camera 29 and to be capable of acquiring and interpreting the captured image. The interpretation of the captured image may be performed by the AI program executed by the CPU 121. Alternatively, the interpretation of the captured image may be performed by an AI program executed by a processing apparatus such as a CPU installed in another computer (a server or a management device) connected to the processing apparatus 10 via a network.

The controller 120 can be configured by installing, on the computer, the above-described program stored in the external memory 127. The external memory 127 includes, for example, a magnetic disk such as an HDD, an optical disk such as a CD, a magneto-optical disk such as an MO, and a semiconductor memory such as a USB memory or an SSD. The memory 123 or the external memory 127 is configured as a computer-readable recording medium. Hereinafter, the memory 123 and the external memory 127 are generally and simply referred to as a "recording medium." In this specification, the term "recording medium" may indicate a case of including the memory 123, a case of including the external memory 127, or a case of including both the memory 123 and the external memory 127. The program may be provided to the computer using a communication means such as the Internet or a dedicated line, instead of using the external memory 127.

### (2) Substrate Processing Process

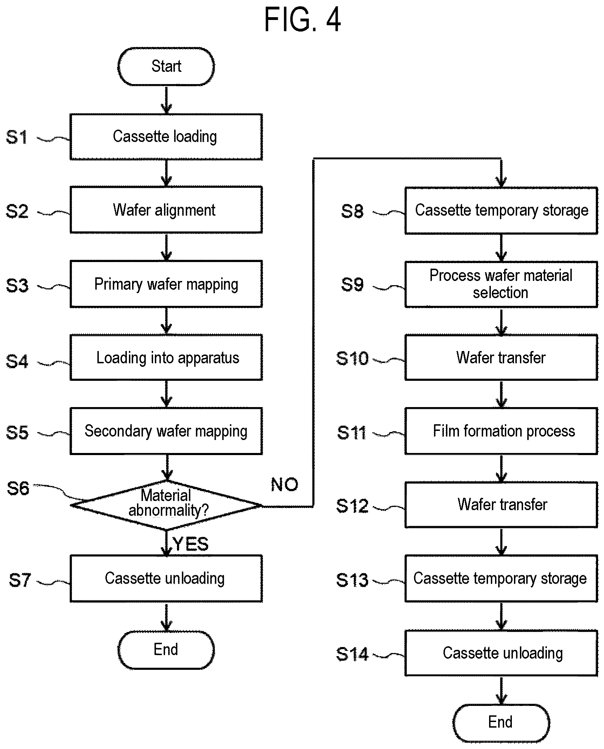

Next, a substrate processing method using the reaction tube 31 of the processing apparatus 10 will be described with reference to FIG. 4. Here, a film formation process of forming a film on the wafer 1 is described as an example of one process of manufacturing a semiconductor device. In the following description, operation of each component constituting the processing apparatus 10 is controlled by the controller 120.

### (Cassette Loading: S1)

The cassette 2 loaded with the wafers 1 before processing is placed on (loaded into) the cassette stage 13 of the cassette deliverer 12 by an external transferrer (not shown) or human assistance. The wafers 1 in the cassette 2 are in a vertical posture. In addition, before or after this operation, information indicating materials of the wafers 1 (material information) accommodated in the placed cassette 2 is provided from a host controller or by a person.

### (Wafer Alignment: S2)

First, the wafers 1 are aligned by the wafer posture aligners 14 using the notches or the like of the wafers 1.

### (Primary Wafer Mapping: S3)

Next, the cassette stage 13 rotates the cassette 2 by 90 degrees so that the wafers 1 in the cassette 2 are brought into a horizontal posture. Then, while the wafers 1 are in the horizontal posture in the cassette stage 13, the robot arm 18 is raised so that a sensor installed on the robot arm 18 scans the cassette 2 from bottom to top. As a result, presence or absence of the wafers (the number of wafers) is detected.

### (Loading into Device: S4)

The cassette 2 on the cassette stage 13 is held by the robot arm 18 and is loaded into the apparatus (the auxiliary cassette shelf 16 of the cassette holding chamber 60) from the cassette deliverer 12.

### (Secondary Wafer Mapping: S5)

The plurality of wafers 1 arranged and accommodated in the cassette 2 placed on the auxiliary cassette shelf 16 is collectively captured by the camera 29, and a two-dimensional image is acquired. Based on a plurality of pixel values corresponding to the plurality of wafers 1 in the acquired two-dimensional image, a material of each of the plurality of wafers 1 is identified. More specifically, an image of a region of interest (RoI) is extracted from the acquired two-dimensional image for each wafer of the plurality of wafers 1 such that an edge of each wafer is included. Then, the materials of the wafers 1 are identified using a pre-trained model that is trained to receive image data of the image of the RoI as input and output values indicating the materials of the wafers. By using the pre-trained model, accuracy of material identification can be improved. Details of secondary wafer mapping will be described later. In addition, the secondary wafer mapping is not limited to being performed for the cassette on the auxiliary cassette shelf 16 and may be performed for the cassette on the cassette stage 13 as well.

### (Material Abnormality Determination: S6)

Based on the material information provided in step S1, materials of the plurality of wafers 1 accommodated in and loaded into the cassette 2 are managed. When a cassette 2 with different types of wafers 1 mixed together is loaded, whether processing in the reaction tube 31 can be continued is determined based on a material identification result obtained by the secondary wafer mapping in step S5. For example, when the above-described material information and the materials identified in step S5 do not match, a material abnormality is determined. In a case where processing can be continued, the process proceeds to step S8, and in a case where processing cannot be continued, the material abnormality is determined and the process proceeds to step S7. Accordingly, depending on a processing temperature in the reaction tube 31, wafers 1 of purposes or types that cannot withstand the processing temperature are controlled so as not to be loaded into the reaction tube 31.

The material abnormality may be determined based on the processing temperature, the materials of wafers provided in step S1, and materials of the wafers identified in step S5. For example, in a case where the materials of the wafers provided in step S1 is SiC, the materials of the wafers identified in step S5 include Si, and the processing temperature is equal to or higher than a melting point of Si, an abnormality is determined and the process proceeds to step S7. In other cases, materials are determined to be normal and the process proceeds to step S8. In a case where the processing temperature is lower than the melting point of Si, materials are determined to be normal, and a mixture of SiC wafers and Si wafers is permitted. In other words, in some cases, processing can be continued even when SiC wafers and Si wafers are mixed. In this specification, the processing temperature refers to a temperature of the wafers 1 or a temperature in the process chamber 32, and this applies to the following description as well. However, even in a case where the material information in step S1 and the determination result in step S5 do not match, when the determination result in step S5 is sufficiently reliable and when processing can be continued using wafers in another cassette, materials are not determined to be abnormal. In such a case, the mismatched materials of the wafers are considered as the materials indicated by the determination result in step S5.

### (Cassette Unloading: S7)

When a material abnormality is determined in step S6, the corresponding cassette is unloaded. That is, the cassette 2 becomes removable. At the same time, an alarm or the like is issued to facilitate the cassette on the cassette stage 13 to be taken out of the housing 11.

### (Cassette Temporary Storage: S8)

Next, the cassette 2 mapped on the auxiliary cassette shelf 16 is transferred to the cassette shelf 15 or another shelf of the auxiliary cassette shelf 16 by the robot arm 18 and is temporarily stored.

### (Process Wafer Material Selection: S9)

When a certain batch processing is scheduled, prior to an actual wafer transfer in step S10, whether a wafer required for the batch processing can be selected from among cassettes accommodated in the cassette holding chamber 60 is determined. The determination is performed using the material information for each wafer managed in step S6. For example, when wafers of a plurality of materials are accommodated in the apparatus, a wafer material can be selected in accordance with film formation process conditions. Details are the same as those in step S10, and therefore description thereof is omitted. When the determination is successful and a previous batch processing is completed, the batch processing can be started.

### (Wafer Transfer: S10)

When a certain batch processing is started, the cassette 2 is sequentially moved by the robot arm 18 from the cassette shelf 15 or the auxiliary cassette shelf 16 to a transfer shelf located at a position facing the wafer transferrer 19 of the cassette shelf 15. The wafers 1 in the cassette 2 placed on the transfer shelf are sequentially transferred to the boat 25 by the wafer transferrer 19. In this case, the wafer transferrer 19 is controlled with reference to a boat map which is a map information indicating, for each slot of the boat 25, from which slot of which cassette 2 the wafers are to be transferred.

When the cassette 2 with different types of wafers 1 mixed together is loaded, the wafer transferrer 19 is controlled such that, based on the material identification result obtained by the secondary wafer mapping in step S5, the wafers 1 of corresponding materials are placed in respective slots of the boat 25 which holds the plurality of wafers 1 in the reaction tube 31.

### (Film Formation Process: S11)

Subsequently, the boat 25 is loaded into the reaction tube 31 by the boat elevator 22. When the loading of the boat 25 into the reaction tube 31 is completed, an atmosphere inside the process chamber 32 is controlled so that pressure inside the process chamber 32 becomes a predetermined pressure. In addition, the temperature in the process chamber 32 is controlled by a heater so as to reach a predetermined temperature, and, for example, a precursor gas and a reaction gas are supplied into the process chamber 32 to form a film on the wafer 1. After the film formation process, the boat 25 is discharged from the reaction tube 31 by the boat elevator 22.

### (Wafer Transfer: S12)

Subsequently, the wafers 1 which are completely processed in the boat 25 are sequentially transferred to the cassette 2 on the transfer shelf by the wafer transferrer 19.

### (Cassette Temporary Storage: S13)

Subsequently, the cassette 2 on the transfer shelf is sequentially transferred by the robot arm 18 to the cassette shelf 15 or the auxiliary cassette shelf 16 and is temporarily stored.

### (Cassette Unloading: S14)

When the cassette 2 is taken out of the processing apparatus 10, the cassette 2 is transferred to the cassette stage 13 of the cassette deliverer 12 by the robot arm 18 from the cassette shelf 15 or the auxiliary cassette shelf 16. Next, the cassette 2 is rotated by 90 degrees by the cassette stage 13 so that the access opening faces upward.

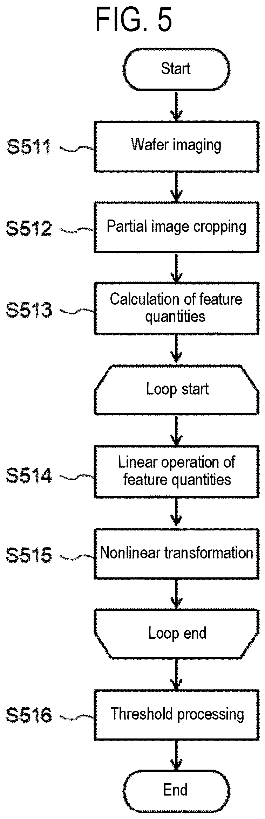

Details of the secondary wafer mapping will be described with reference to FIGS. 5 to 8.

### (Step S511)

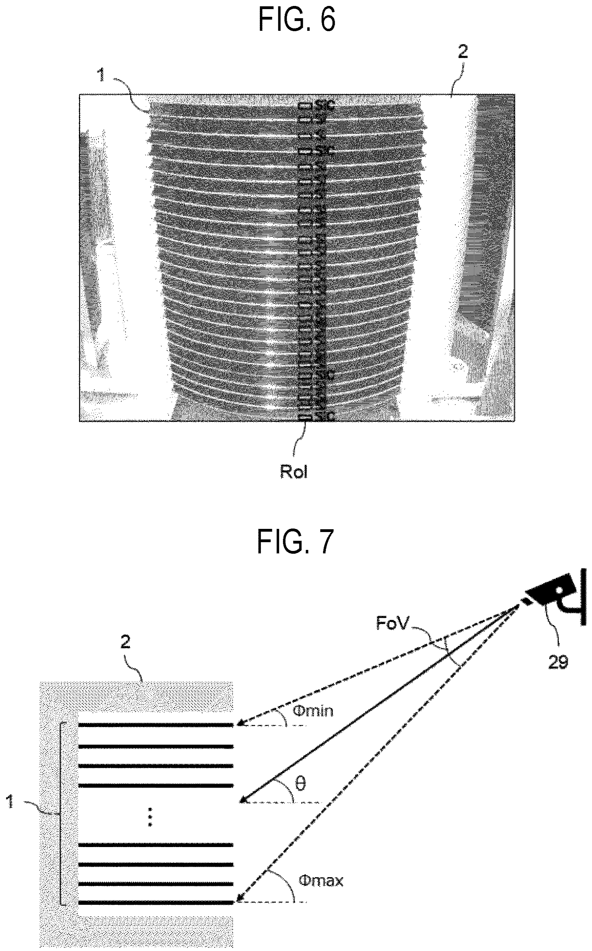

The wafers 1 in the cassette 2 are collectively captured by the camera 29, and an image is acquired. FIG. 7 illustrates a range of imaging angles of the camera 29. An angle θ formed between an extension line of a bisector of a field of view (FoV) and a horizontal direction of an installation surface of the processing apparatus 10 is defined as an installation angle of the camera 29. When θ is excessively large, the wafers 1 are projected with narrow pitches, and wafer edges at lower portions of the slots may overlap. When θ is excessively small, the wafers 1 are projected with wide pitches, and background color may be visible between wafers at upper portions of the slots.

Therefore, for the lowermost slot of the cassette 2 placed on the auxiliary cassette shelf 16, θ is set to be equal to or less than an upper limit angle (φmax). For the uppermost slot, θ is set to be equal to or greater than a lower limit angle (φmin). A camera with a wide FoV within a range that satisfies φmax and φmin may be used. This allows a distance between the camera 29 and the cassette 2 to be shortened. Here, φmax and φmin are defined by the following equations (1) and (2). $φmax = {tan}^{- 1} \left(wafer pitch in cassette/wafer thickness\right)$ (1) $φmin = {tan}^{- 1} \left(wafer pitch in cassette/wafer diameter\right)$ (2)

### (Step S512)

A partial image of an RoI, which is set in advance to correspond to each wafer, is cropped. FIG. 6 illustrates an example of an image of the wafers 1 inside the cassette 2 captured by the camera. The RoI is set on edge portions (the foremost side) of the wafer 1 exposed from a bottom opening of the cassette 2 (i.e., an opening opposite to the access opening). The RoI is set at a fixed position relative to a position of the cassette 2. In addition, the notches of the wafers 1 are aligned in advance by the wafer posture aligners 14 so as to be positioned directly below (i.e., at a center of the bottom opening). Since the RoI is fixedly set relative to the position of the cassette 2, it is possible to capture an image of the RoI without rotating the wafers 1. The RoI is a rectangular region including a region corresponding to a portion of the surfaces (main surface) of the wafers 1 or a region corresponding to the notches of the wafers 1. Accordingly, characteristic features for identifying, for example, Si wafers and SiC wafers are captured. An illumination light source 294 is disposed annularly around the camera 29 and is integrally configured with the camera 29. As a result, reflection of light at the edge of the wafer 1 becomes a substantially specular reflection of light, and the specularly reflected light enters the camera 29, enabling bright illumination. A position of the RoI is fine-tuned such that a pixel centroid of an edge or contour, extracted by a machine vision technique, is located at a predetermined position in the RoI.

### (Step S513)

A plurality of feature quantities is calculated from each RoI. Any well-known RoI can be used. The feature quantities include, as simple examples, an average (a) of pixel values in the RoI, the number (b) of pixels, pixel values of which are equal to or greater than the average, and the number (c) of pixels with pixel value gradients equal to or greater than a predetermined value. For example, since a Si wafer and a SiC wafer differ in wafer thickness (the Si wafer is thicker than the SiC wafer), feature quantities that are sensitive to wafer thickness are used.

### (Step S514)

The feature quantities are subjected to a linear operation (e.g., affine transformation) using parameters that are trained, which will be described later. A training process will be described later.

### (Step S515)

A result of the linear operation is non-linearly transformed by an activation function (e.g., a rectified linear unit (ReLU) function).

Steps S514 and S515 are appropriately repeated using corresponding parameters. This corresponds to hidden layers of a convolutional neural network (CNN).

### (Step S516)

An output of the activation function is linearly transformed, and threshold processing is performed, which yields a determination result. Accordingly, materials can be identified based on non-linear operations of the plurality of feature quantities. In a simple example, a value obtained by multiplying the average (a) of pixel values and the number (b) of pixels multiplied by predetermined weights and adding the resulting values is used as a predetermined threshold for threshold processing. That is, steps S514 and S515 may be omitted. The material identification result may be displayed by adding indications of SiC or Si to the captured image, for example, as shown in FIG. 6.

### (Machine Learning)

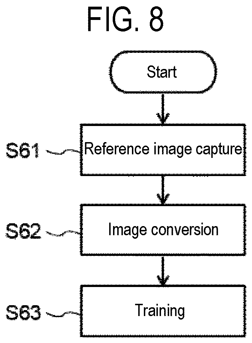

Next, a flow of machine learning performed in advance will be described with reference to FIG. 8.

### (Step S61: Reference Image Capture)

A plurality of images (see FIG. 6) is captured by the camera 29 as reference images. During the image capture, a plurality of reference images is obtained by reproducing differences in states of the cassette deliverer 12, differences in colors of the cassette 2, differences in wafer types, and differences in positions or inclinations of wafers in slots of the cassette 2. The different states of the cassette deliverer 12 include, for example, a state in which a shutter in front of the cassette deliverer 12 is open and no cassette 2 is present on the cassette stage 13 (in which stray light may be introduced) and a state in which the shutter is closed and the cassette 2 is present on the cassette stage 13. The differences in wafer types indicate which type of wafer is accommodated in each slot. The differences in inclinations of wafers are also effective for ensuring generalization capability regarding differences in bevel shapes that vary among SiC wafer manufacturers.

Furthermore, an image used to create a machine learning model may be an image of the processing apparatus 10 that is to be captured and identified or the image may be obtained from an apparatus (a master device) other than the processing apparatus 10 to be captured and identified or another computer (e.g., a management device). The master device is, for example, another processing apparatus equipped with an auxiliary cassette shelf and a camera in substantially the same arrangement relationship as the processing apparatus 10. The other computer is installed on the same network as the processing apparatus 10.

### (Step S62: Image Conversion)

The plurality of reference images captured in step S61 is converted into images suitable for learning. For example, the plurality of reference images is converted into grayscale images or HSV images. The HSV images are images in which colors are indicated by a combination of three components, that is, hue, saturation, and value.

In addition, the number of images may be increased by performing spatial filter processing such as sharpening (unsharp masking), correction such as tone-curve correction, and transformation such as parallel translation or rotation under various conditions.

### (Step S63: Training)

Using the images prepared in step S62, an AI (a convolutional neural network or the like) is trained. That is, a relationship between image information and label information is trained through machine learning, thereby generating a machine learning model. Training is performed by updating parameters of a CNN using an error backpropagation method.

As described above, by using the machine learning flow of FIG. 8, a pre-trained model can be configured as follows.

The pre-trained model is a model trained for outputting the materials of the wafers 1 from an image obtained by capturing the wafers 1 inside the cassette 2. The pre-trained model is trained of the differences in bevel shape, notch shape, wafer thickness, and surface reflectance due to different materials of the wafers. As a result, characteristic features for identifying, for example, Si wafers and SiC wafers are learned.

Parameters of the pre-trained model are trained using training data in which image information obtained by capturing the wafers 1 in the cassette 2 with the camera 29 is associated with wafer material information. After the cassette 2 is moved to the auxiliary cassette shelf 16, image information obtained by capturing the wafers 1 in the cassette 2 with the camera 29 is received as input. The input image information is subjected to arithmetic processing based on the parameters, and a value indicating the wafer material is output.

### (Modification)

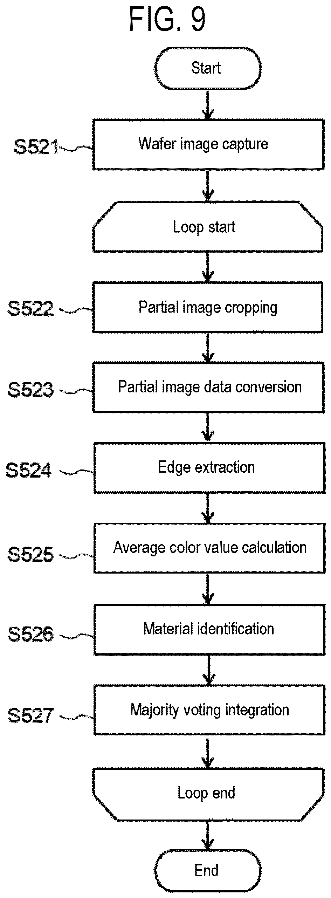

A flow of secondary mapping according to a modification will be described with reference to FIG. 9.

### (Step S521)

As in step S511, the wafers 1 in the cassette 2 are collectively captured by the camera 29, and an image is obtained.

The following processing (S522 to S527) is repeated for each wafer.

### (Step S522)

For each wafer, partial images of three set RoIs are cropped. Three positions to be set are the center of the bottom opening of the cassette 2 and positions at both sides thereof.

### (Step S523)

A partial image of each RoI is converted into HSV-format data and grayscale data.

### (Step S524)

Edge extraction (e.g., Canny edge) is performed from the grayscale partial image of each RoI, and the number of pixels extracted as edges (the number of edges) is counted.

### (Step S525)

An average color value in the partial image in the HSV format is calculated. The average color value may not be the average of entire pixels in the partial image and an average color value of pixels located above the edges detected in step S524 may be calculated instead. This makes it possible to eliminate the influence of a wafer located immediately below the target wafer.

### (Step S526)

The feature quantity includes at least one selected from the group of the number of edges extracted from the RoI by a computer vision technique and the average color value. The feature quantity may include both the number of edges extracted from the RoI and the average color value.

The material is identified based on at least one selected from the group of a similarity between the number of edges and the pre-trained number of edges and a similarity between the average color value and a pre-trained average color value. More specifically, the material is identified based on an absolute value of a difference between the number of edges and the pre-trained number of edges and an absolute value of a difference between the average color value and the pre-trained average color value.

For example, for each RoI, the number of edges and the average color value are compared with the pre-trained number of edges and the pre-trained average color value obtained from a Si wafer. When an absolute value of a difference between the number of edges and the pre-trained number of edges or an absolute value of a difference between the average color value and the pre-trained average color value is equal to or less than a predetermined threshold, the wafer is determined to be the Si wafer, otherwise, the wafer is determined to be a non-Si wafer (e.g., a SiC wafer).

### (Step S527)

The determination results of the respective RoIs are integrated by a majority voting method. In this example, the learning process is unsupervised. Further, the learning is performed by optimizing a threshold using an algorithm such as a steepest descent method (corresponding to the error backpropagation method in the CNN).

During operation of the apparatus, for wafers identified as Si and wafers identified as non-Si, the calculated feature quantities (the number of edges and the average color value) may be accumulated. Subsequently, an average value of the feature quantities may be calculated, or the pre-trained parameters (the number of edges and the average color value) may be updated. Furthermore, from such pre-trained parameters, an accuracy indicating that a wafer is a non-Si wafer (corresponding to one node of an output layer of the CNN) may be calculated, and compared with an accuracy indicating that the wafer is a Si wafer to identify the material.

According to the present disclosure, one or more of the following effects (a) to (f) can be obtained.
(a) A plurality of wafers can be collectively identified at arbitrary locations to determine whether the wafers are Si wafers or transparent or opaque SiC wafers.
(b) When a cassette with different types of wafers mixed together is loaded, the materials can be identified, so that a cassette loading error can be determined by the apparatus.
(c) When material information about a plurality of wafers in the cassette, obtained from a host apparatus or registered in advance, and the material identified by a first mapping apparatus do not match, an alarm can be issued. As a result, it becomes possible to notify the operator of a cassette loading error.
(d) Once material identification is completed on the auxiliary cassette shelf, depending on a processing temperature performed in the reaction tube, wafers of purposes or types that cannot withstand the processing temperature are controlled so as not to be loaded into the reaction tube. This enables efficient apparatus operation even when different materials are mixed.
(e) Material identification can be performed on the auxiliary cassette shelf. Accordingly, when a cassette with different types of wafers mixed together is loaded, substrates of corresponding materials can be placed in the respective slots of the boat based on the material identification result obtained by secondary wafer mapping.
(f) Since identification is performed by imaging a part of the wafers, a mechanism for rotating a plurality of wafers in order to image the wafers is not required.

The present disclosure is not limited to the embodiment described above and includes various modifications. For example, the embodiment described above is explained in detail for ease of understanding of the present disclosure and is not necessarily limited to the configurations described. The above-described embodiment and modification can be used in appropriate combinations. In such cases, the processing procedures and conditions can be the same as those of the aforementioned embodiment or modification.

In the above-described embodiment, an example of a batch-type substrate processing apparatus that processes a plurality of substrates simultaneously is described. The present disclosure is not limited to the above-described embodiment and can be applied to, for example, a single-wafer-type substrate processing apparatus that processes one or several substrates simultaneously. While the single-wafer processing apparatus may not be equipped with a cassette shelf or a cassette transfer device, it is possible to perform mapping involving material identification as in the present disclosure, using a substrate transferrer or other mapping means within a load port or a vacuum load lock chamber. Further, in the above-described embodiment, an example in which a film is formed using a substrate processing apparatus with a hot-wall-type process furnace is described. The present disclosure is not limited to the above-described embodiment and can also be suitably applied to, for example, a case in which a film is formed using a substrate processing apparatus with a cold-wall-type process furnace.

Even when these substrate processing apparatuses are used, each process can be performed according to the same processing procedures or under the same processing conditions as those of the above-described embodiment, and the same effects as those of the above-described embodiment are obtained.

According to the present disclosure, it is possible to identify a material of a substrate.

While certain embodiments are described, these embodiments are presented by way of example, and are not intended to limit the scope of the disclosure. Indeed, the embodiments described herein may be embodied in a variety of other forms. Furthermore, various omissions, substitutions and changes in the form of the embodiments described herein may be made without departing from the spirit of the disclosure. The accompanying claims and their equivalents are intended to cover such forms or modifications as would fall within the scope and spirit of the disclosure.

## Claims

1. A substrate type identification apparatus, comprising:
an imager (29) configured to acquire a two-dimensional image by collectively capturing a plurality of substrates (1), which are arranged and accommodated in a substrate container (31), from a direction inclined relative to main surfaces of at least one of the plurality of substrates (1); and
an identifier (120) configured to be capable of individually identifying respective materials of the plurality of substrates (1) based on a plurality of pixel values in the acquired two-dimensional image corresponding to the plurality of substrates (1).

2. The substrate type identification apparatus of Claim 1, wherein the substrate container (31) is a cassette (2).

3. The substrate type identification apparatus of Claim 1, wherein the identifier (120) is configured to be capable of identifying the respective materials by using a pre-trained model trained to receive, as input, image data of an image of a region of interest (RoI) that is extracted from the acquired two-dimensional image for each substrate (1) of the plurality of substrates (1) such that an edge of each substrate (1) is included, and to output values indicating the materials of the substrates (1).

4. The substrate type identification apparatus of Claim 3, further comprising a light source (294) integrated with the imager (29) to illuminate the substrates (1) such that specularly reflected light from the edge of each substrate (1) is incident on the imager (29).

5. The substrate type identification apparatus of Claim 3, wherein the RoI includes a region corresponding to a portion of a surface of a corresponding substrate (1).

6. The substrate type identification apparatus of Claim 3, wherein the RoI includes a region corresponding to a notch of a corresponding substrate (1).

7. The substrate type identification apparatus of any one of Claims 1 to 6, wherein the identifier (120) uses feature quantities that are sensitive to thicknesses of the substrates (1).

8. The substrate type identification apparatus of any one of Claims 3 to 7, wherein the pre-trained model is trained on differences in bevel shape, notch shape, substrate thickness, and surface reflectance caused by different materials of the substrates (1).

9. The substrate type identification apparatus of any one of Claims 1 to 8, wherein the identifier (120) is configured to be capable of extracting a plurality of feature quantities for each region of interest (RoI) and identifying the respective materials based on non-linear operations of the plurality of feature quantities.

10. The substrate type identification apparatus of Claim 9, wherein the feature quantities include at least one selected from the group of the number of edges extracted from the RoI by a computer vision technique and an average color value.

11. The substrate type identification apparatus of Claim 10, wherein the identifier (120) is configured to be capable of identifying the materials based on at least one selected from the group of a similarity between the number of edges and a pre-trained number of edges and a similarity between the average color value and a pre-trained average color value.

12. The substrate type identification apparatus of any one of Claims 3 to 7, wherein the RoI is fine-tuned such that a pixel centroid of an edge or a contour, extracted by a computer vision technique, is located at a predetermined position in the RoI.

13. A substrate processing apparatus (10), comprising:
a transferrer (19) configured to transfer the substrates (1) identified by the substrate type identification apparatus of Claim 1; and
a process chamber (32) configured to process the substrates (1) transferred by the transferrer (19).

14. A method of processing a substrate (1), comprising:
(a) collectively capturing a plurality of substrates (1), which are arranged and accommodated in a substrate container (31), from a direction inclined relative to main surfaces of the plurality of substrates (1) by an imager (29) configured to acquire a two-dimensional image;
(b) individually identifying, by an identifier (120), materials of the plurality of substrates (1) based on a plurality of pixel values in the two-dimensional image corresponding to edges of the plurality of substrates (1); and
(c) discharging the plurality of substrates (1) from the substrate container (31), transferring the substrates (1) to a process chamber (32), and processing the substrates (1) in the process chamber (32).

15. A method of manufacturing a semiconductor device, comprising the method of Claim 14.
